# EUROPEAN PATENT APPLICATION

(11) **EP 1 215 729 A2**
(43) Date of publication of application: **19.06.2002**
(21) Application number: 01310545.7
(22) Date of filing: 18.12.2001
(51) Int. Cl.: H01L 27/146

(54) **Image pickup apparatus**

(30) Priority: 18.12.2000 JP 2000383925; 12.12.2001 JP 2001378124
(71) Applicant: CANON KABUSHIKI KAISHA, Tokyo (JP)
(72) Inventor: Sonoda, Kazuhiro, c/o Canon Kabushiki Kaisha, Ohta-ku, Tokyo (JP); Takahashi, Hidekazu, c/o Canon Kabushiki Kaisha, Ohta-ku, Tokyo (JP)
(74) Representative: Beresford, Keith Denis Lewis

(57) **Abstract**

An image pickup apparatus includes a pixel area 103 including a plurality of pixels 101, and a substrate, 104 on which the pixel area is integrated, wherein the centers of the pixel area and substrate substantially coincide with each other. This arrangement can attain reduction of the size of an image pickup apparatus compared to known devices.

## Description

### BACKGROUND OF THE INVENTION

### Field of the Invention

The present invention relates to an image pickup apparatus for picking up an object image.

### Related Background Art

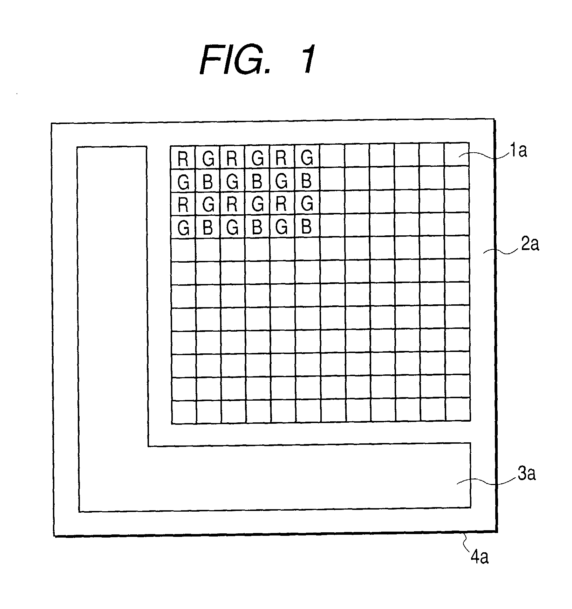

Fig. 1 shows an arrangement of a conventional solid-state image pickup element. A pixel 1a has a photoelectric conversion portion such as a photodiode. Such pixels are two-dimensionally arrayed to form a pixel area 2a for picking up an object image.

A peripheral circuit 3a includes vertical and horizontal shift registers for reading out a signal from the pixel, and a power supply circuit for supplying power. The pixel area 2a and peripheral circuit 3a are integrated on a semiconductor substrate 4a.

In the arrangement of the pixel area and peripheral circuit on the semiconductor substrate shown in Fig. 1, an output from the solid-state image pickup element suffers shading or the like in case that the solid-state image pickup element is formed with being planarized by CMP (Chemical Mechanical Polishing) or the like.

Further, the apparatus is difficult to downsize due to the positional relationship between the solid-state image pickup element and the lens or the like.

### SUMMARY OF THE INVENTION

It is an object of the present invention to downsize an image pickup apparatus.

To achieve the above object, according to an aspect of the present invention, there is provided an image pickup apparatus comprising
a pixel area including a plurality of pixels, and
a substrate on which the pixel area is integrated,
wherein a center of the pixel area and that of the substrate substantially coincide with each other.

According to another aspect of the present invention, there is provided an image pickup apparatus comprising
a substrate on which a pixel area including a plurality of pixels is arranged,
a lens arranged to form light into an image on the pixel area, the lens being not integrated with the pixel area, and
processing circuits arranged on at least two sides facing each other across the pixel area, adapted to perform predetermined processing,
wherein the substrate and the lens are united.

According to still another aspect of the present invention, there is provided an image pickup apparatus comprising
a substrate on which a pixel area including a plurality of pixels is arranged,
a lens arranged to form light into an image on the pixel area, the lens being not integrated with the pixel area,
a processing circuit arranged on at least one of two sides facing each other across the pixel area, adapted to perform predetermined processing, and
a dummy circuit or pad arranged on the other one of the two sides,
wherein the substrate and the lens are united.

The above and other objects, features, and advantages of the present invention will be apparent from the following description in conjunction with the accompanying drawings.

### BRIEF DESCRIPTION OF THE DRAWINGS

Fig. 1 is a plan view showing an arrangement of a conventional solid-state image pickup element;
Fig. 2 is a schematic plan view showing a solid-state image pickup element according to the first embodiment of the present invention;
Figs. 3A and 3B are schematic plan and sectional views, respectively, showing the solid-state image pickup element in Fig. 2;
Fig. 4 is a schematic perspective view showing the solid-state image pickup element in Fig. 2;
Fig. 5 is an enlarged view showing the vicinity of a pixel area in Fig. 2;
Fig. 6 is an equivalent circuit diagram showing a pixel in Fig. 5;
Figs. 7A and 7B are schematic plan and sectional views, respectively, showing a solid-state image pickup element as an example for comparison with the first embodiment of the present invention;
Fig. 8 is a schematic sectional view showing the vicinity of a photodiode used in the solid-state image pickup element;
Figs. 9A and 9B are sectional views showing the states of a dielectric interlayer shown in Fig. 8 before and after CMP;
Figs. 10A and 10B are views showing thickness in the pixel areas and peripheral circuits of the solid-state image pickup elements in Figs. 2, 7A, and 7B;
Fig. 11 is a graph showing an output from each pixel when the solid-state image pickup elements of Figs. 2, 7A, and 7B are driven;
Fig. 12 is a schematic plan view showing another solid-state image pickup element according to the first embodiment of the present invention;
Fig. 13 is a schematic plan view showing still another solid-state image pickup element according to the first embodiment of the present invention;
Fig. 14 is a sectional view showing details of an image pickup unit shown in Fig. 3B;
Figs. 15A and 15B are plan views showing a solid-state image pickup element according to the second embodiment of the present invention; and
Fig. 16 is a block diagram showing a solid-state image pickup system according to the third embodiment of the present invention.

### DETAILED DESCRIPTION OF THE PREFERRED EMBODIMENTS

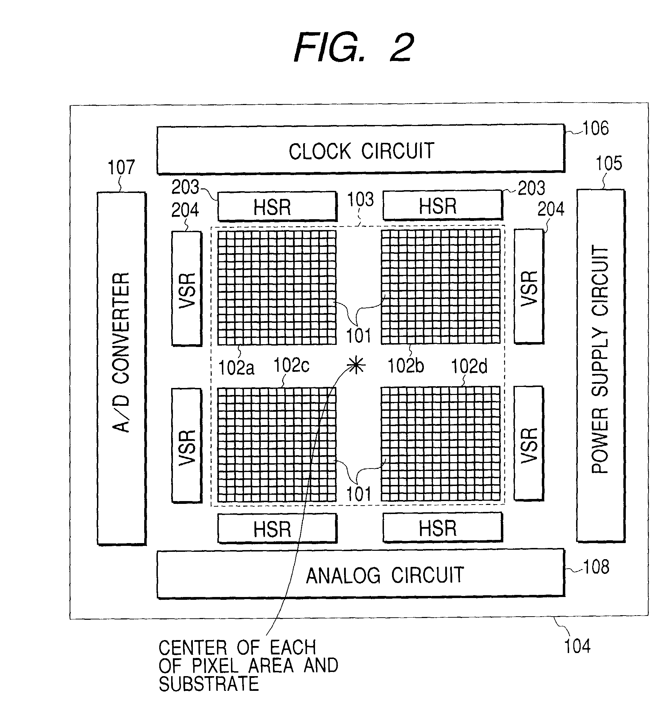

Fig. 2 is a schematic plan view showing a solid-state image pickup element according to the first embodiment of the present invention. Fig. 2 shows a so-called four-lens solid-state image pickup element. In Fig. 2, each pixel 101 has a photodiode. Each of pixel groups 102a to 102d is formed with a two-dimensional array of pixels 101. A pixel area 103 includes the pixel groups 102a to 102d. Horizontal shift registers (HSR) 203 and vertical shift registers (VSR) 204 read out outputs from the pixels 101 of the pixel groups 102a to 102d. A power supply circuit 105 serves as a driving source for the solid-state image pickup element that is arranged around the pixel area 103. A clock circuit 106 supplies a clock signal to the horizontal and vertical shift registers 203 and 204. An A/D converter (ADC) 107 converts a signal from each pixel 101 from an analog signal into a digital signal. An analog circuit 108 includes an auto gain control circuit for correcting a signal, and a corrected double sampling circuit. These units are integrated on a semiconductor substrate 104.

In the first embodiment, as shown in Fig. 2, the pixel area 103 having a plurality of pixel groups 102a to 102d is arranged at the center of the substrate 104, and the power supply circuit 105, clock circuit 106, A/D converter 107, and analog circuit 108 are so arranged as to surround the pixel area 103.

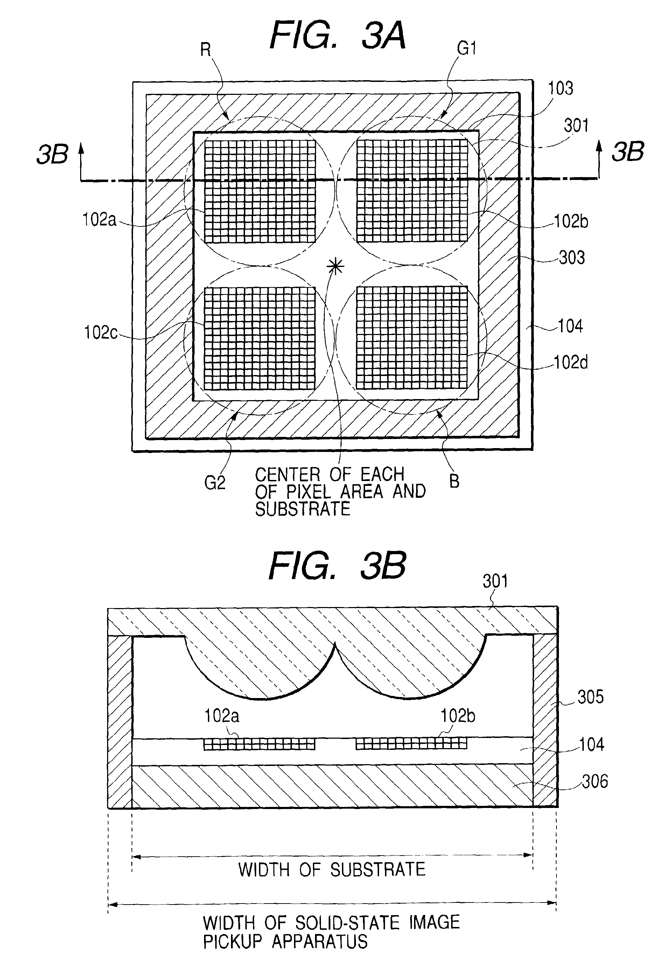

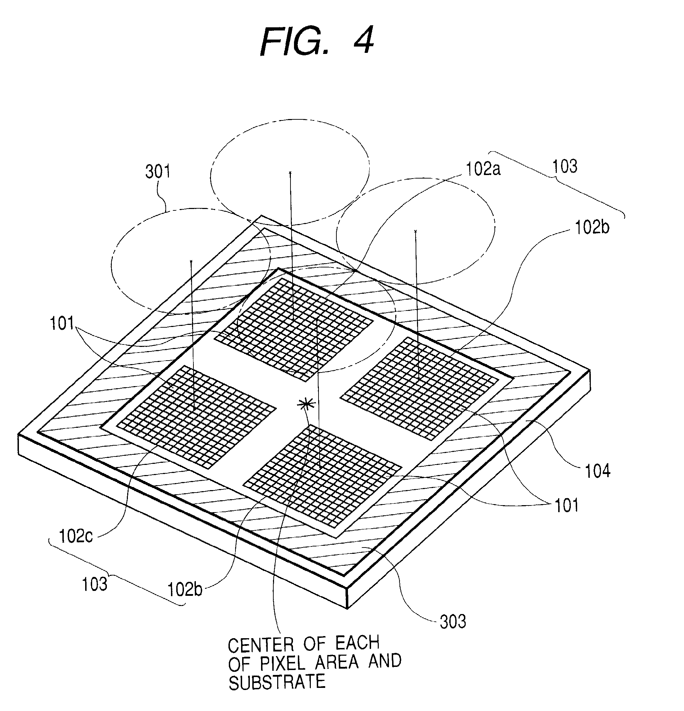

Fig. 3A is a schematic plan view showing an image pickup unit including the solid-state image pickup element in Fig. 2 and other members such as a lens. Fig. 3B is a sectional view taken along the line 3B - 3B in Fig. 3A. Fig. 4 is a schematic perspective view showing the solid-state image pickup element in Fig. 2.

In Figs. 3A and 3B, image pickup lenses 301 allow incident light to enter the pixels 101 of the pixel groups 102a to 102d. A support member 305 is disposed at the peripheral portion of the substrate 104 to support the image pickup lenses 301. The semiconductor substrate 104 is mounted on a mounting board 306. A peripheral circuit 303 corresponds to the horizontal shift register 203, the vertical shift register 204, amplifiers 201, the power supply circuit 105, the clock circuit 106, the A/D converter 107, and the analog circuit 108 in Fig. 2. An R (Red) color filter is arranged in front of the pixel group 102a. G (Green) color filters are arranged in front of the pixel groups 102b and 102c. A B (Blue) color filter is arranged in front of the pixel group 102d.

As shown in Figs. 3A and 3B, the centers of the semiconductor substrate 104 and pixel area 103 coincide with each other in the image pickup unit of the first embodiment. The image pickup lens is united with the semiconductor substrate and mounting board.

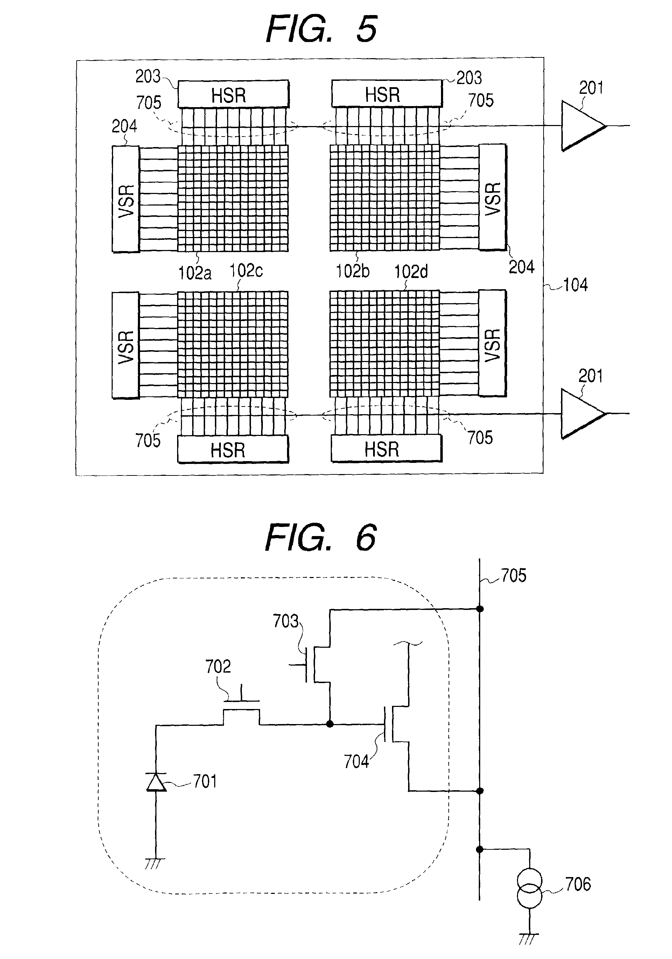

Fig. 5 is an enlarged view showing the vicinity of the pixel area 103 in Fig. 2. In Fig. 5, vertical output lines 705 are used to read out outputs from the pixel groups 102a to 102d. The amplifiers 201 are connected to the vertical output line 705 to amplify outputs read out from the pixel groups 102a to 102d.

Fig. 6 is an equivalent circuit diagram of the pixel 101 shown in Fig. 5. In Fig. 6, a photodiode 701 photoelectrically converts incident light. A transfer switch 702 transfers an electrical signal to a floating diffusion (FD) region. A reset switch 703 resets electric charges in the FD region and photodiode 701. A source follower amplifier 704 obtains an amplified signal based on the transferred electrical signal. A constant current source 706 is used to read out the amplified signal to the vertical output line 705.

The operation in Figs. 2 to 6 will be explained briefly. While the solid-state image pickup apparatus is ON by the power supply circuit 105, light from an object to be picked up is collected by the image pickup lenses 301 and enters the pixels 101 of the pixel groups 102a to 102d. In each pixel 101, the photodiode 701 converts the incident light into an electrical signal.

Based on a clock signal from the clock circuit 106, the vertical shift register 204 outputs a signal for turning on the transfer switch 702. Then, the transfer switch 702 is turned on to transfer to the floating diffusion (FD) region the electrical signal photoelectrically converted by the photodiode 701. The transferred electrical signal turns on the gate of the source follower amplifier 704, and an amplified signal is read out to the vertical output line 705 by means of the source follower amplifier 704 and a constant current source 706.

Subsequently, based on a clock signal from the clock circuit 106, the horizontal shift register 203 sequentially inputs to the amplifier 201 amplified signals read out to the respective vertical output lines 705. The amplifier 201 amplifies each input amplified signal and outputs it to the analog circuit 108. The analog circuit 108 performs color processing, white balance processing, γ processing, and shading correction on the amplified signal, and outputs the processed signal to the A/D converter 107. The A/D converter 107 converts the output signal from an analog signal into a digital signal. The digital signal is externally read out or saved in a memory (not shown).

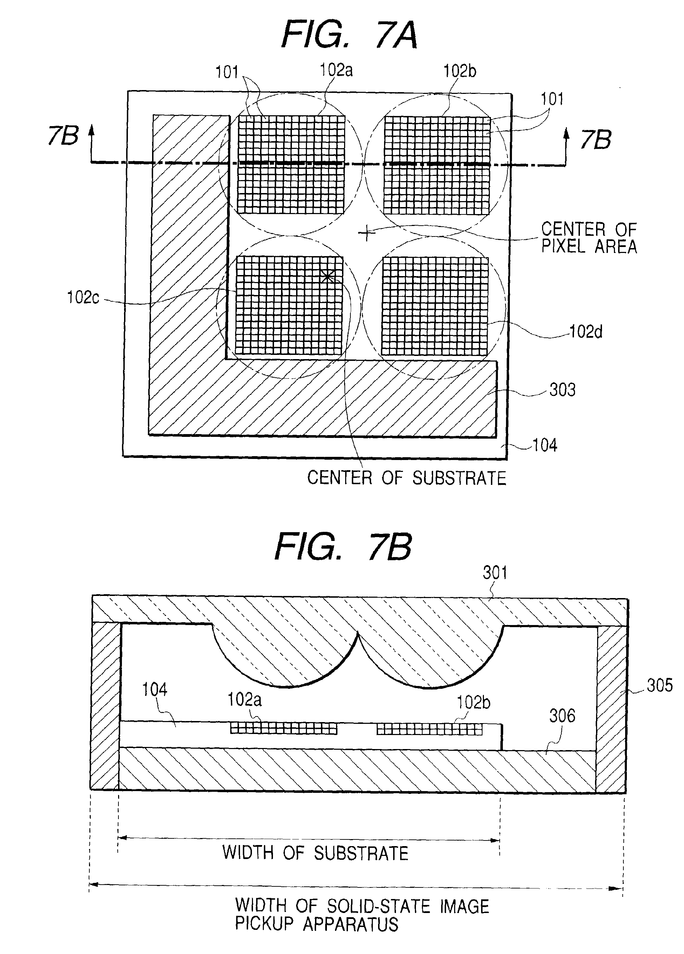

Fig. 7A is a schematic plan view showing an image pickup unit as an example for comparison for explaining the merits of downsizing the image pickup unit described above. Fig. 7B is a sectional view taken along the line 7B - 7B in Fig. 7A. Figs. 7A and 7B correspond to Figs. 4A and 4B, respectively.

In the example for comparison, as shown in Figs. 7A and 7B, the peripheral circuit 303 is arranged in an L shape on two adjacent sides around the pixel groups 102a to 102d. If the peripheral circuit 303 is arranged in an L shape and the centers of the pixel area and image pickup lens are made to coincide with each other, an unnecessary space is required between the pixel area and the support member, resulting in a very wide image pickup unit. In other words, the image pickup unit of the present embodiment can realize a size smaller than that of the image pickup unit shown in Figs. 7A and 7B.

It is noted that technological advantages to the merit of the circuit arrangement of the solid-state image pickup element described above are obtained particulary in case that CMP is adopted as one of manufacturing steps of the solid-state image pickup element. However, the present invention is not limited to the use of CMP. To meet two demands for high resolution and high sensitivity in the solid-state image pickup element, the photodiode area is ensured by decreasing the wiring area ratio by wiring micropatterning, and the light converging ratio is increased by disposing a microlens on the pixel.

For high integration by wiring micropatterning, a solid-state image pickup element with a multilayered wiring structure is fabricated particularly by a design rule of 0.35 µm or less. To planarize a dielectric interlayer between wiring layers, the dielectric interlayer of the element is polished by CMP.

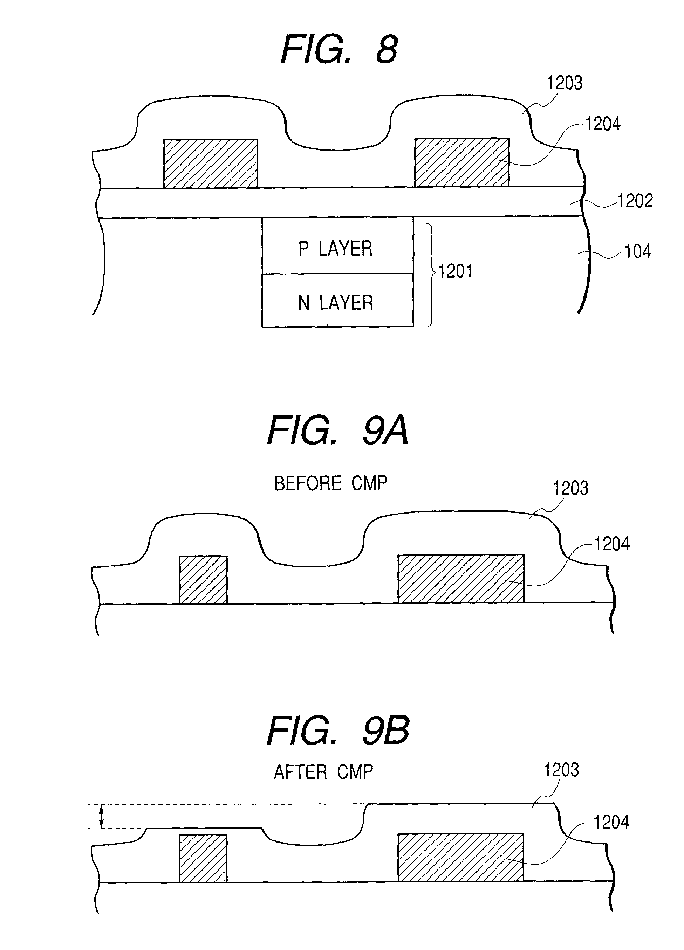

Fig. 8 is a schematic sectional view showing the vicinity of a photodiode serving as a photoelectric conversion element used in the solid-state image pickup element. As shown in Fig. 8, a multilayered wiring structure made up of an insulating layer 1202, wiring layer 1204, and dielectric interlayer 1203 is formed on a photodiode 1201 having P and N layers formed in the semiconductor substrate 104.

More specifically, the wiring layer 1204 is formed on the insulating layer 1202. The dielectric interlayer 1203 is formed on the wiring layer 1204 in order to reduce a step formed by the wiring layer. The dielectric interlayer 1203 is polished by CMP and planarized. A wiring layer (not shown) and the like are formed on the planarized dielectric interlayer 1203. A passivation layer is formed on the top layer.

The influence of the step of the wiring layer 1204 is reduced in this manner to prevent a pattern defect such as disconnection of the wiring layer (not shown), or multiple interference of light caused by the difference in refractive index between the layers 1202 to 1204 on the photodiode 1201. However, the dielectric interlayer 1203 suffers step nonuniformity on its surface depending on the wiring density in the wiring layer 1204.

Fig. 9A is a sectional view showing a state wherein, e.g., an SiO-based material is coated as the dielectric interlayer 1203 onto the wiring layer 1204 shown in Fig. 8 but has not yet been polished by CMP. Fig. 9B is a sectional view showing a state wherein the dielectric interlayer 1203 is polished by CMP from the state of Fig. 9A. As shown in Figs. 9A and 9B, the wiring layer 1204 includes a high-wiring-density region (right in Figs. 9A and 9B) and a low-wiring-density region (left in Figs. 9A and 9B). The dielectric interlayer 1203 is satisfactorily polished in the low-wiring-density region but is not sufficiently polished in the high-wiring-density region.

If a wiring layer or passivation layer (not shown) is formed in this state, the layer thickness of the multilayered layer varies. A ripple is generated in terms of the spectral sensitivity characteristics of the multilayered layer. As a result, the photodiode sensitivity may greatly change depending on a slight wavelength difference. Variations in the layer thickness of the multilayered layer vary the spectral sensitivity characteristics in accordance with the layer thickness, resulting in sensitivity variations for the same wavelength.

If thickness of the dielectric interlayer of the multilayered wiring structure changes, the capacitance between wiring layers changes, thereby varying circuit characteristics such as the gain. These variations are not preferable because they cause sensitivity variations between pixels even for uniform light, and shading in an output from the solid-state image pickup element in which a plurality of photodiodes 1201 are arranged.

The variations in the layer thickness of the multilayered layer are prevented by clearly separating high- and low-wiring-density regions from each other and reducing the step of the dielectric interlayer planarized by CMP. Note that the pixel area has a wiring density as low as about 30%, and the peripheral circuit such as a processing circuit for processing a signal read out from the pixel area has a wiring density as high as about 70%.

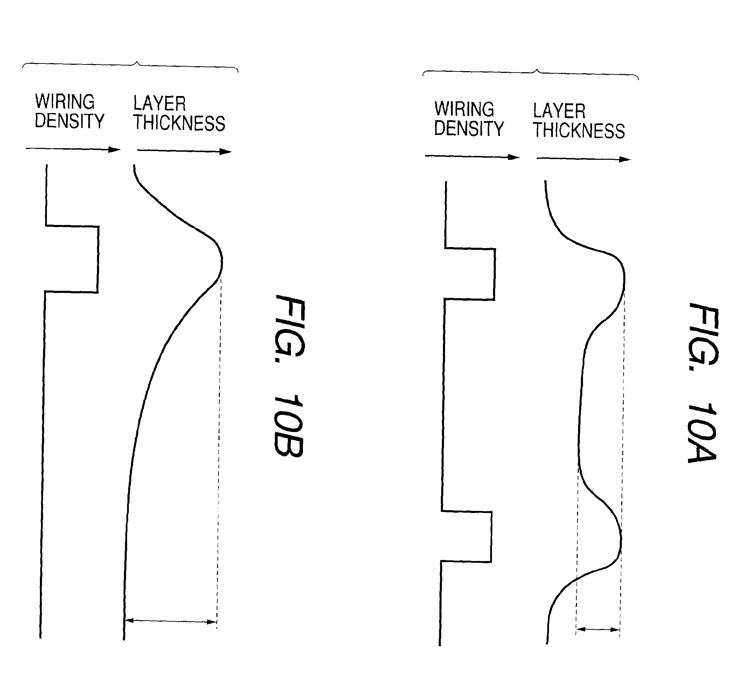

Fig. 10A is a view showing the layer thicknesses in the pixel area 103 and peripheral circuit 303 of the solid-state image pickup element in Fig. 2. Fig. 10B is a view showing the layer thicknesses in the pixel area 103 and peripheral circuit 303 of the solid-state image pickup element in Figs. 7A and 7B.

As shown in Fig. 10A, the solid-state image pickup element of Fig. 2 has two high-wiring-density regions. The layer thickness is larger in these regions and smaller in the area between them. To the contrary, as shown in Fig. 10B, the solid-state image pickup element of Figs. 7A and 7B has one high-wiring-density region. The layer thickness is smaller as being apart from this region. From Figs. 10A and 10B, the layer thickness changes. The layer thickness difference makes it difficult to obtain uniform sensitivity. For this reason, the solid-state image pickup element shown in Fig. 2 hardly varies in sensitivity, compared to the solid-state image pickup element shown in Figs. 7A and 7B.

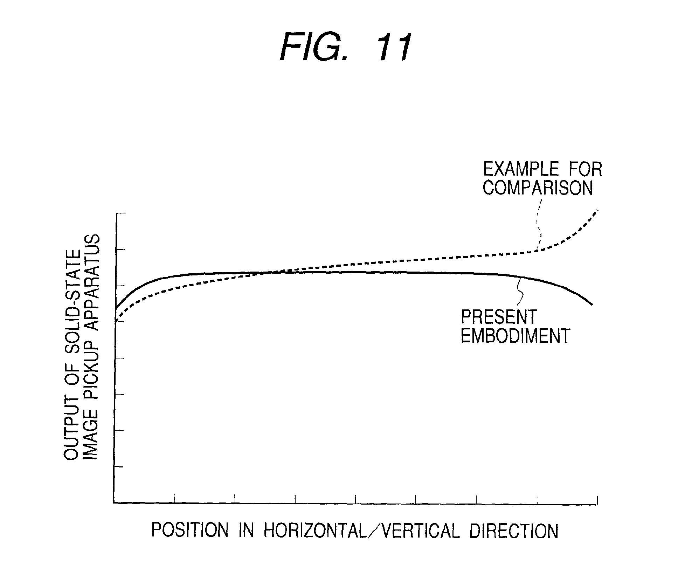

Fig. 11 is a graph showing an output from each pixel 101 when the solid-state image pickup elements of Figs. 2, 7A, and 7B are driven. As shown in Fig. 11, the solid-state image pickup element shown in Fig. 2 rarely varies in output in comparison with the solid-state image pickup element shown in Figs. 7A and 7B. If the layer thickness of the multilayered layer greatly varies, as shown in Fig. 11, shading occurs in an output signal in the horizontal or vertical direction of the pixel area even with incident light of uniform intensity.

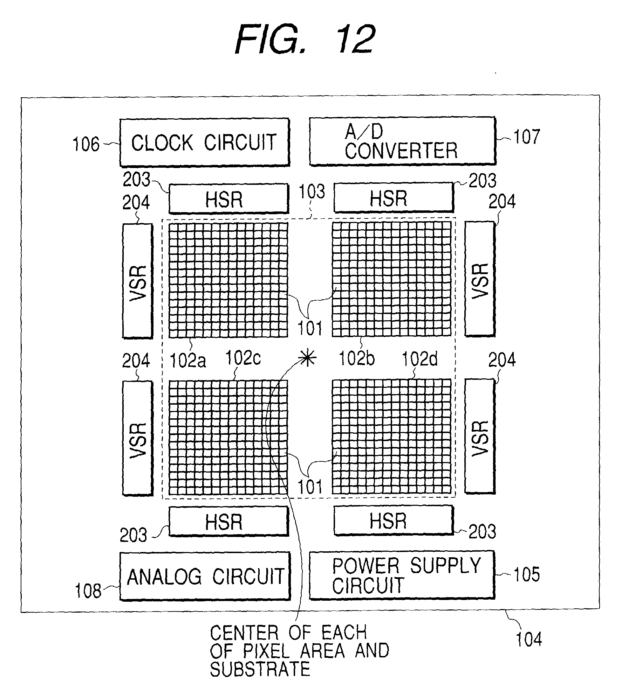

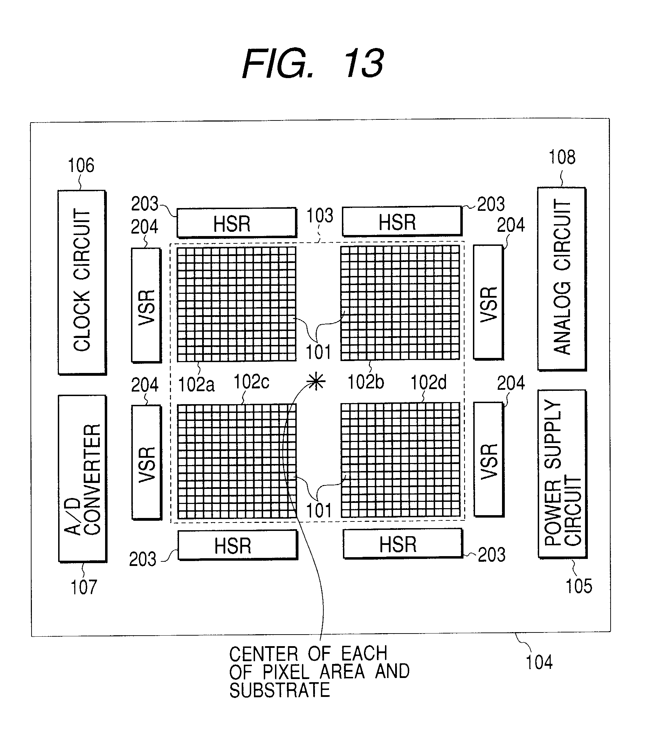

The peripheral area 303 is formed on all the sides of the pixel area 103 in the first embodiment of the present invention, but may be formed on two sides facing each other across the pixel area 103. For example, as shown in Fig. 12, the power supply circuit 105, clock circuit 106, A/D converter 107, and analog circuit 108 may be arranged near the respective horizontal shift registers 203. Alternatively, as shown in Fig. 13, the power supply circuit 105, clock circuit 106, A/D converter 107, and analog circuit 108 may be arranged near the respective vertical shift registers 204.

In the above description, each pixel 101 in the so-called pixel area 103 uses a CMOS sensor. However, the pixel 101 may use any sensor such as an AMI (Amplified MOS Imager), CMD (Charge Modulation Device), or CCD (Charge Coupled Device).

In the above-described arrangement, the solid-state image pickup element and mounting board are separately arranged. Alternatively, the solid-state image pickup element may play the role of the mounting board instead of adopting the mounting board separately from the solid-state image pickup element.

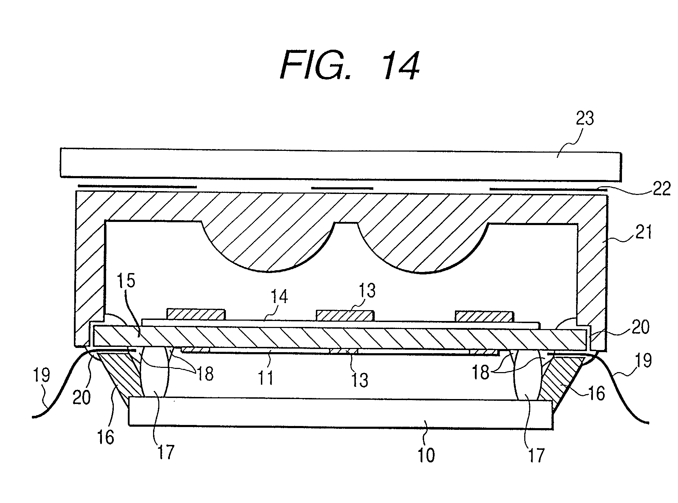

An arrangement in Fig. 3B will be described in detail with reference to Fig. 14.

A solid-state image pickup element (CMOS sensor) 10 is formed by integrating a pixel area, peripheral circuit, and the like. A light-shielding member 13, color filter 11, infrared cut filter 14, and the like are mounted on a glass plate 15. A sealing resin 16 fills the gap between the solid-state image pickup element and the glass plate.

Gold bumps 17 support the glass plate 15 and have conductivity. A conductive adhesive 18 connects the gold bumps to the glass plate and has conductivity. Wires (FPC) 19 establish external electrical connection. A lens-fixing adhesive 20 fixes a lens. An image pickup lens 21 forms light into an image on the solid-state image pickup element. An aperture 22 and passivation glass 23 are arranged on the image pickup lens 21.

In the above arrangement, the solid-state image pickup element plays the role of the mounting board without using the mounting board in addition to the solid-state image pickup element. The solid-state image pickup element is made of a material which enables the element to also function as the mounting board.

This arrangement can further reduce the cost and size.

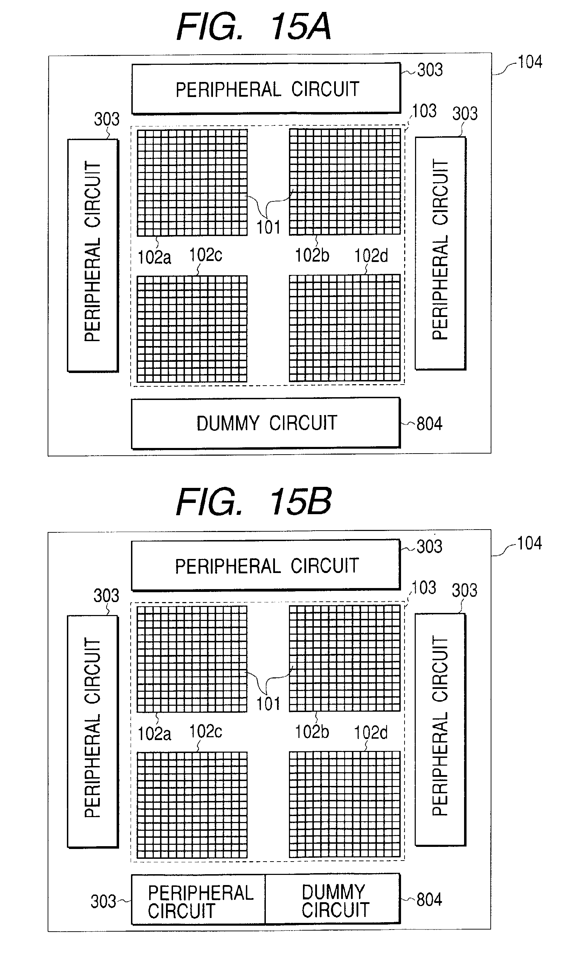

Figs. 15A and 15B are plan views showing a solid-state image pickup apparatus according to the second embodiment of the present invention, and correspond to Fig. 2. In Figs. 15A and 15B, a dummy circuit 804 has the same wiring density as that of peripheral circuits 303. In Figs. 15A and 15B, the same reference numerals as in Fig. 2 denote the same parts.

The solid-state image pickup apparatus shown in Figs. 15A and 15B attains the same sensitivity as that of the solid-state image pickup apparatus shown in Fig. 2 when the peripheral circuits 303 can only be arranged on three sides of a pixel area 103 in terms of the design, or can be arranged on all the sides of the pixel area 103 but on only the half of side for one of all the sides. Note that a pad may be used instead of the dummy circuit 804.

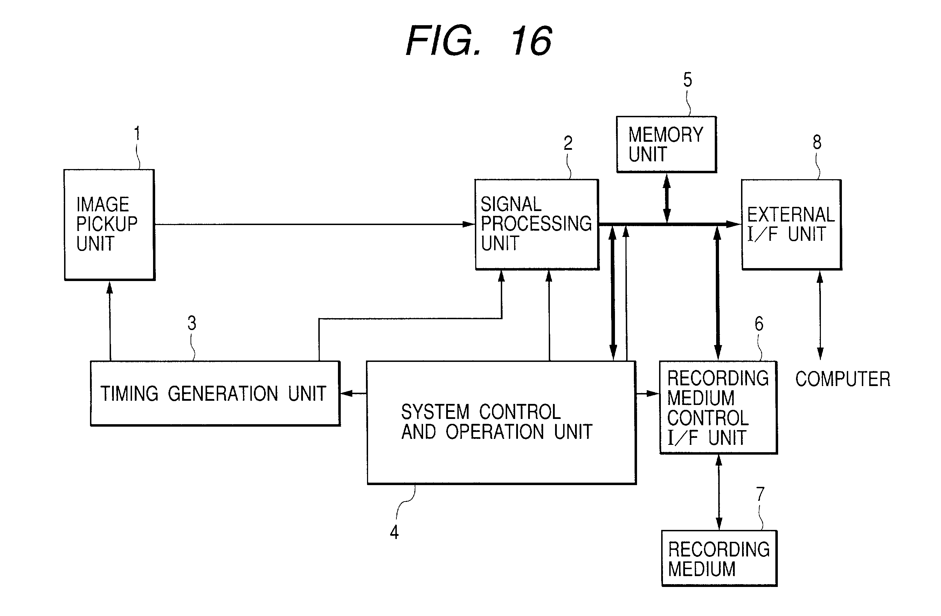

Fig. 16 is a block diagram showing an image pickup system using the image pickup unit described in the first or second embodiment. In Fig. 16, an image pickup unit 1 is one described in the first or second embodiment and captures an object image as an image signal. A signal processing unit 2 performs various correction processes on image data output from the image pickup unit, compresses data, and synthesizes image data from respective pixel groups. A timing generation unit 3 generates various timing signals to the image pickup unit 1 and signal processing unit 2. A system control and operation unit 4 controls various arithmetic operations and the whole image pickup system. A memory unit 5 temporarily stores image data. A recording medium control I/F unit 6 records/reads out data on/from a recording medium. A detachable recording medium 7 such as a semiconductor memory is used to record/read out image data. An external interface (I/F) unit 8 communicates with an external computer or the like.

The first to third embodiments have exemplified a plurality of pixel groups, an object image is divided into a plurality of images, and light is incident on the respective pixel groups. This arrangement can shorten the focal length, which is advantageous particularly in size reduction. However, it may also be possible to adopt only one pixel group in place of a plurality of pixel groups and arrange color filters in, e.g., a Bayer layout on the pixel group.

As has been described above, the image pickup unit can be reduced in size and profile. In addition, a high-quality image can be obtained.

Many widely different embodiments of the present invention may be constructed without departing from the scope of the present invention. It should be understood that the present invention is not limited to the specific embodiments described in the specification, except as defined in the appended claims.

## Claims

1. An image pickup apparatus comprising:
a pixel area including a plurality of pixels; and
a substrate on which said pixel area is integrated,
wherein a center of said pixel area and that of said substrate substantially coincide with each other.

2. An apparatus according to claim 1, wherein said substrate includes processing circuits arranged to perform a predetermined processing, which are integrated on said substrate on at least two sides facing each other across said pixel area.

3. An apparatus according to claim 1, wherein said substrate includes a processing circuit arranged to perform a predetermined processing, which is integrated on said substrate on at least one of two sides facing each other across said pixel area, and a dummy circuit or pad which is arranged on the other side.

4. An apparatus according to any preceding claim wherein said substrate includes an area planarized by chemical mechanical polishing.

5. An apparatus according to any preceding claim wherein said pixel area is formed by arranging a plurality of pixel groups each having a two-dimensional array of pixels, and
said apparatus further comprises lenses arranged correspondingly to the respective pixel groups to form light into images on the pixel groups.

6. An apparatus according to claim 5, further comprising color filters arranged for the respective pixel groups,
wherein said color filters are not integrated on said substrate.

7. An image pickup system comprising:
an image pickup apparatus as defined in any preceding claim;
a signal processing circuit arranged to process a signal from said image pickup apparatus; and
a memory arranged to store the signal from said signal processing circuit.

8. An image pickup apparatus comprising:
a substrate on which a pixel area including a plurality of pixels is arranged;
a lens arranged to form light into an image on said pixel area, said lens being not integrated with said pixel area; and
processing circuits arranged on at least two sides facing each other across the pixel area to perform predetermined processing,
wherein said substrate and said lens are united.

9. An apparatus according to claim 8, wherein said lens is fixed on at least two sides facing each other at a periphery of said pixel area.

10. An apparatus according to claim 8, wherein a glass is arranged above said pixel area, and said lens is fixed to said glass.

11. An apparatus according to any one of claims 8 to 10 wherein said pixel area is formed on a semiconductor substrate different from said substrate, and said semiconductor substrate is mounted on said substrate.

12. An apparatus according to any one of claims 8 to 11 wherein said pixel area is integrated on said substrate.

13. An apparatus according to any one of claims 8 to 12 wherein said processing circuits include scan circuits arranged to sequentially scan the pixels, said scan circuits being arranged on at least two sides facing each other across said pixel area.

14. An apparatus according to any one of claims 8 to 13 wherein said processing circuits include one of an A/D conversion circuit, a clock circuit arranged to supply a clock signal, a power supply circuit, and an analog circuit including at least one of an auto gain controller and a corrected double sampling circuit, arranged on at least one of two sides facing each other across said pixel area, and one of the A/D conversion circuit, the clock circuit, and the analog circuit, arranged on not said one but the other of the two sides.

15. An image pickup system comprising:
an image pickup apparatus as defined in any one of claims 8 to 14;
a signal processing circuit arranged to process a signal from said image pickup apparatus; and
a memory arranged to store the signal from said signal processing circuit.

16. An image pickup apparatus comprising:
a substrate on which a pixel area including a plurality of pixels is arranged;
a lens arranged to form light into an image on said pixel area, said lens being not integrated with said pixel area;
a processing circuit arranged on at least one of two sides facing each other across the pixel area to perform a predetermined processing; and
a dummy circuit or pad arranged on the other of the two sides,
wherein said substrate and said lens are united.

17. An apparatus according to claim 16, wherein said lens is fixed on at least two sides facing each other at a periphery of said pixel area.

18. An apparatus according to claim 16, wherein a glass is arranged above said pixel area, and said lens is fixed to said glass.

19. An apparatus according to any one of claims 16 to 18 wherein said pixel area is formed on a semiconductor substrate different from said substrate, and the semiconductor substrate is mounted on said substrate.

20. An apparatus according to any one of claims 16 to 19 wherein said pixel area is integrated on said substrate.

21. An apparatus according to any one of claims 16 to 20 wherein said processing circuit includes a scan circuit arranged to sequentially scan the pixels.

22. An apparatus according to any one of claims 16 to 21 wherein said processing circuit includes one of an A/D conversion circuit, a clock circuit for supplying a clock signal, a power supply circuit, and an analog circuit including at least one of an auto gain controller and a corrected double sampling circuit.

23. An image pickup system comprising:
an image pickup apparatus as defined in any one of claims 16 to 22;
a signal processing circuit arranged to process a signal from said image pickup apparatus; and
a memory arranged to store the signal from said signal processing circuit.
